# EUROPEAN PATENT APPLICATION

(11) **EP 4 064 810 A1**
(43) Date of publication of application: **28.09.2022**
(21) Application number: 22163986.7
(22) Date of filing: 24.03.2022
(51) Int. Cl.: H05K 7/20

(54) **CHASSIS AND POWER SUPPLY SYSTEM**

(30) Priority: 25.03.2021 CN 202110318449
(71) Applicant: Huawei Digital Power Technologies Co., Ltd., Shenzhen, 518043 (CN)
(72) Inventor: Xu, Bo, Shenzhen, 518129 (CN); Meng, Hao, Shenzhen, 518129 (CN)
(74) Representative: Thun, Clemens

(57) **Abstract**

This application provides a chassis and a power supply system. The chassis includes a body and a heat dissipation component configured to dissipate heat for heat generation modules in the body. The heat dissipation component includes a spacer board and at least one fan disposed on the spacer board. The spacer board divides space in the body into an annular air duct. The annular air duct includes a first air duct surrounded by the spacer board and a second air duct located between the spacer board and sidewalls of the body, and the first air duct and the second air duct are communicated. The first air duct has space for carrying the heat generation modules. When air circulates in the first air duct and the second air duct, heat generated by the heat generation modules is taken away. In the foregoing technical solution, the annular air duct is formed in the body by using the spacer board, so that air flow can be implemented with a small quantity of fans, and temperatures of the air in the body are balanced, thereby improving a heat dissipation effect, reducing a quantity of fans, reducing space occupied by the fans, and increasing space for placing components in the body.

## Description

### TECHNICAL FIELD

This application relates to the field of heat dissipation technologies, and in particular, to a chassis and a power supply system.

### BACKGROUND

With rapid development of photovoltaic industry technologies, new energy sources such as solar energy and wind power are widely applied to power grids in recent years, resulting in an increasingly complex working environment of a DC-DC chassis in the power grids. Internal electronic components of the DC-DC chassis are concentrated, which generate a large amount of heat, causing a great challenge to system safety. Currently, a heat dissipation manner used for the DC-DC chassis is using a fan to directly blow an electronic component that generates heat. However, a heat dissipation manner in which each electronic component is correspondingly provided with a fan leads to a relatively large quantity of fans, and a position for placing the fans is greatly limited, resulting in relatively low space utilization of a body. Therefore, a low-cost and efficient heat dissipation solution is urgently needed for internal application scenarios.

### SUMMARY

This application provides a chassis and a power supply system, to improve a layout in a chassis and improve an effect of heat dissipation in the chassis.

According to a first aspect, a chassis is provided. The chassis includes a body, and the body is configured to accommodate components of the chassis. The components are heat generation components, and the heat generation modules may be modules of different types, such as chips or active components. When disposed, the heat generation modules are fixed in the chassis. The chassis is further provided with a heat dissipation component configured to dissipate heat for the heat generation modules. The heat dissipation component includes a spacer board and at least one fan disposed on the spacer board. The spacer board is located in the body and disposed along sidewalls of the body. The spacer board divides space in the body into an annular air duct. The annular air duct includes a first air duct surrounded by the spacer board and a second air duct located between the spacer board and the sidewalls of the body, and the first air duct and the second air duct are communicated. The first air duct has space for carrying the heat generation modules. The at least one fan is configured to drive air in the body to circularly flow in the first air duct and the second air duct. When air circulates in the first air duct and the second air duct, heat generated by the heat generation modules is taken away. In the foregoing technical solution, the annular air duct is formed in the body by using the spacer board, so that air flow can be implemented with a small quantity of fans. Air in a high-temperature area (an area in which the heat generation modules are located) and air in a low-temperature area (another area other than the area in which the heat generation modules are located) in the body flow, so that temperatures of the air in the body are balanced, thereby improving a heat dissipation effect, reducing a quantity of fans, reducing space occupied by the fans, and increasing space for placing components in the body.

In a specific possible implementation, there are two second air ducts, and the two second air ducts are located on an outer side of the first air duct. This improves a heat dissipation effect for the heat generation components.

In a specific possible implementation, the two second air ducts are communicated to form a U-shaped air duct. This improves a heat dissipation effect for the heat generation components.

In a specific possible implementation, the spacer board includes a first sub-board, a second sub-board, and a third sub-board. The first sub-board is located between the second sub-board and the third sub-board to form a U-shaped structure. The at least one fan is disposed on the first sub-board.

In a specific possible implementation, the first sub-board is detachably connected to the second sub-board and the third sub-board by using bolted connection components. Alternatively, the first sub-board, the second sub-board, and the third sub-board are integrated. Therefore, the spacer board may be formed in different manners.

In a specific possible implementation, the at least one fan is disposed at a central position of the first sub-board. This improves an air supply effect of the fan.

In a specific possible implementation, there may be one fan. This minimizes space occupied by the fan.

In a specific possible implementation, the body includes a first sidewall and a fourth sidewall disposed oppositely, and an opening of the U-shaped structure of the spacer board faces the fourth sidewall. A first gap for communicating the first air duct and the second air duct is formed between the second sub-board and the fourth sidewall. A second gap for communicating the first air duct and the second air duct is formed between the third sub-board and the fourth sidewall. Communication between the first air duct and the second air duct is implemented by designing lengths of the second sub-board and the third sub-board.

In a specific possible implementation, the chassis further includes the heat generation modules disposed in the body. Vertical distances from the first gap and the second gap to the first sidewall are less than a vertical distance between any heat generation module and the first sidewall. This ensures that air can flow through the heat generation module.

In a specific possible implementation, the second sub-board is provided with a first air vent configured to correspond to some of the plurality of heat generation modules. The third sub-board is provided with a second air vent configured to correspond to some of the plurality of heat generation modules. The first air vent communicates the first air duct and the second air duct, and the second air vent communicates the first air duct and the other second air duct. This improves an air flow effect.

In a specific possible implementation, the first air vent and the second air vent each include a plurality of ventilation holes arranged in an array.

In a specific possible implementation, a vertical distance between the first air vent and the first sub -board is less than a vertical distance between a corresponding heat generation module and the first sub-board. A vertical distance between the second air vent and the first sub-board is less than a vertical distance between a corresponding heat generation module and the first sub-board. This ensures that air can flow through the heat generation module.

According to a second aspect, a power supply system is provided. The power supply system includes the chassis and the heat sink according to any one of the implementations. The chassis and the heat sink are stacked. In the foregoing technical solution, the annular air duct is formed in the body by using the spacer board, so that air flow can be implemented with a small quantity of fans. Air in a high-temperature area (an area in which the heat generation modules are located) and air in a low-temperature area (another area other than the area in which the heat generation modules are located) in the body flow, so that temperatures of the air in the body are balanced, thereby improving a heat dissipation effect, reducing a quantity of fans, reducing space occupied by the fans, and increasing space for placing components in the body.

### BRIEF DESCRIPTION OF DRAWINGS

FIG. 1 is a schematic diagram of a heat dissipation structure of a chassis;
FIG. 2 is a schematic diagram of a structure of a chassis according to an embodiment of this application;
FIG. 3 is a schematic diagram of internal air flow in a chassis according to an embodiment of this application;
FIG. 4 is a schematic diagram of a structure of a spacer board according to an embodiment of this application;
FIG. 5 is a schematic exploded diagram of a spacer board and a body according to an embodiment of this application;
FIG. 6 is a schematic diagram of a structure of another second sub-board according to an embodiment of this application; and
FIG. 7 is a schematic diagram of a structure of another chassis according to an embodiment of this application.

### DESCRIPTION OF EMBODIMENTS

A chassis provided in embodiments of this application may be applied to data communication equipment, a server, or an energy device, and is configured to carry electronic components in the device. The electronic components carried in the chassis specifically include an active component and a passive component, such as a capacitor, a resistor, a chip, and an integrated circuit. When the electronic components work, some electronic components such as a chip and a resistor generate a relatively large amount of heat, while some electronic components generate a relatively small amount of heat. For ease of description, space in a body is divided into a high-temperature area and a low-temperature area. The high temperature corresponds to an area in which the electronic components that generate a relatively large amount of heat are located, and the electronic components that generate a relatively large amount of heat are also named as heat generation modules. The low-temperature area corresponds to an area in which the electronic elements that generate a relatively small amount of heat are located and an area in which no electronic element is disposed in the body.

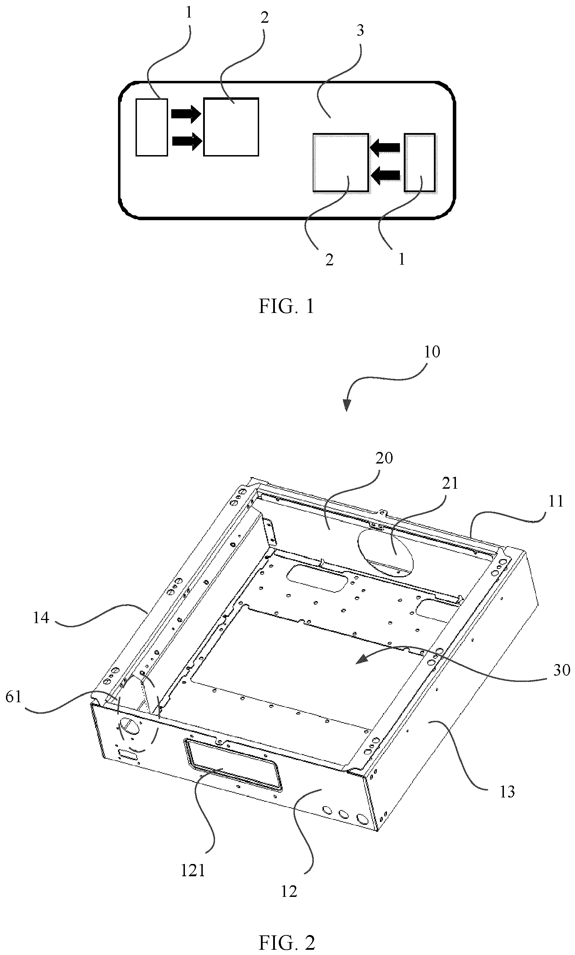

FIG. 1 shows a structure of a chassis. To reduce a temperature in the chassis 3, a fan 1 is used to cool a heat generation module 2. Heat generated by the heat generation module 2 is dissipated to a low-temperature area in the chassis 3 by using the fan 1, to reduce a temperature of a surrounding environment of the heat generation module 2. In FIG. 1, two heat generation modules 2 are shown as an example, and two fans 1 are respectively correspondingly disposed for the two heat generation modules 2. However, when heat dissipation is performed by using the foregoing solution, the fan 1 is close to the heat generation module 2, and a relatively large space needs to be occupied, which affects layout of other components. In addition, each heat generation module 2 needs to correspond to one fan 1, which causes an increase in costs of the chassis 3. Therefore, an embodiment of this application provides a chassis 3. The following describes the chassis 3 with reference to specific accompanying drawings and embodiments.

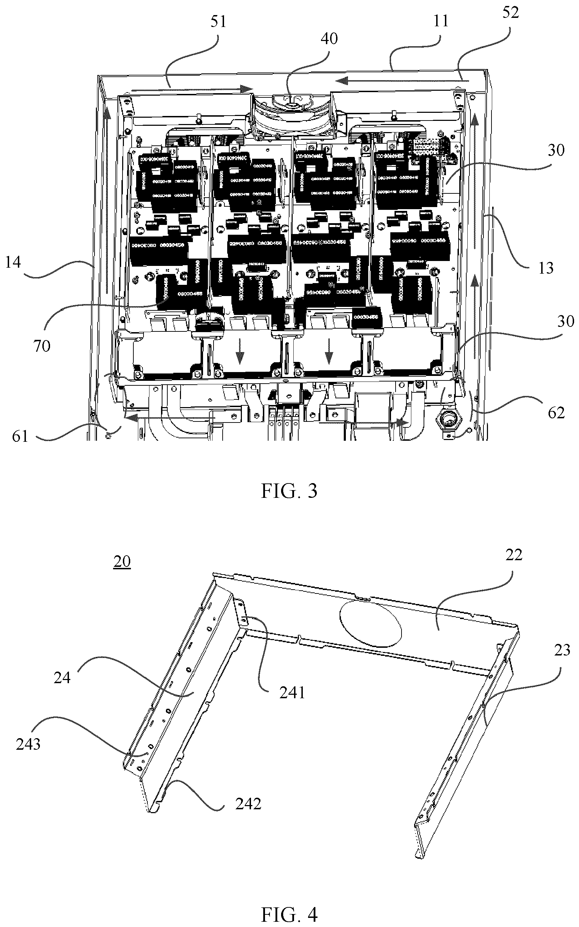

FIG. 2 is a schematic diagram of a structure of a chassis according to an embodiment of this application. FIG. 3 is a schematic diagram of a structure of an air duct of the chassis. The chassis mainly includes a body 10, heat generation modules 70, and a heat dissipation component configured to dissipate heat for the heat generation modules 70. The body 10 is configured to carry the heat generation modules 70 and the heat dissipation component. The heat generation modules 70 are configured to implement electrical functions of the chassis as electronic components of the chassis. The heat dissipation component is configured to implement air flow in the body 10, to balance temperatures of a high-temperature area and a low-temperature area in the body 10, and reduce a temperature around the heat generation modules 70.

As a structural component that carries the heat generation modules 70 and the heat dissipation component, the body 10 may use structures of different shapes. As shown in FIG. 2, the body 10 is a rectangular body 10, and includes a bottom board and sidewalls disposed around the bottom board. For ease of description, the sidewalls are respectively named as a first sidewall 11, a second sidewall 14, a third sidewall 13, and a fourth sidewall 12. The first sidewall 11 and the fourth sidewall 12 are disposed oppositely, the second sidewall 14 and the third sidewall 13 are disposed oppositely, and the four sidewalls and the bottom board surround a space for accommodating the heat generation modules 70 and the heat dissipation component. In addition, the body 10 further includes a cover. The cover covers the four sidewalls and is disposed opposite to the bottom board, to enclose the heat generation modules 70 and the heat dissipation component. In FIG. 2, for ease of illustrating an internal structure of the body 10, the cover is not shown.

An air intake vent 121 is disposed on the fourth sidewall 12. The air intake vent 121 is an interface for connecting an internal space of the body 10 and an external space, and external air may enter the body 10 through the air intake vent 121.

The heat dissipation component includes a spacer board 20 and at least one fan 30 disposed on the spacer board 20. The spacer board 20 is located in the body 10 and disposed along sidewalls of the body 10. As shown in FIG. 2, the spacer board 20 is a U-shaped structure, and the U-shaped structure is nested in the body 10 and disposed along sidewalls of the body 10. An opening of the U-shaped structure faces the fourth sidewall 12, and a sidewall of the U-shaped structure is disposed along the first sidewall 11, the second sidewall 14, and the third sidewall 13.

Further, refer to FIG. 3, the spacer board 20 of the U-shaped structure is spaced from the first sidewall 11, the second sidewall 14, and the third sidewall 13, so that the spacer board 20 divides space in the body 10 into an annular air duct. The annular air duct includes a first air duct 30 and a second air duct (a second air duct a51 and a second air duct b52), and the first air duct 30 and the second air duct are communicated to form the annular air duct. As shown in FIG. 3, the second air duct a51 and the second air duct b52 are respectively arranged on two sides of the first air duct 30 and are respectively communicated with the first air duct 30.

The first air duct 30 is a space surrounded by the spacer board 20. The first air duct 30 is also used as a space for disposing electronic components of the chassis in addition to a channel for air flow in the body 10. Therefore, the first air duct 30 occupies most of the space in the body 10. When the electronic components are disposed in the body 10, the electronic components are located in the first air duct 30, that is, the heat generation modules 70 and non-heat generation modules in the electronic components are located in the first air duct 30. Therefore, when the spacer board 20 is disposed, the spacer board 20 is as close as possible to the sidewalls of the body 10, so that a relatively large space for disposing the heat generation modules 70 is obtained in the body 10.

The second air duct a51 and the second air duct b52 are spaces surrounded by the spacer board 20 and the sidewalls of the body 10. When the spacer board 20 is a U-shaped structure, the second air duct a51 and the second air duct b52 are both inverted L-shaped structures. The second air duct a51 and the second air duct b52 are located on an outer side of the first air duct 30 and form a door frame structure, so that the first air duct 30 is located within the door frame structure. In addition, the second air duct a51 and the second air duct b52 are respectively communicated with the first air duct 30.

Still refer to FIG. 2 and FIG. 3. Sidewalls of the first air duct 30 include the spacer board 20, the bottom board, and the cover, and the first air duct 30 of the annular air duct is surrounded by the structural components. Two ends of the first air duct 30 are provided with openings, an opening at one of the ends is an opening end of the U-shaped structure of the spacer board 20, and an opening at the other end is a through hole 21 disposed on the spacer board 20. The through hole 21 is located on a horizontal part of the U-shaped structure of the spacer board 20. During communication with the second air duct, the through hole 21 and the opening end of the U-shaped structure are respectively communicated with the second air duct a51 and the second air duct b52, so that the first air duct 30 and the second air duct a51 form an annular air duct, and the first air duct 30 and the second air duct b52 form an annular air duct. For example, a first gap 61 and a second gap 62 are disposed between an end of the spacer board 20 far from the first air duct 30 and the fourth sidewall 12. The first gap 61 is a first port through which the second air duct a51 and the first air duct 30 are communicated, and the second gap 62 is a second port through which the second air duct b52 and the first air duct 30 are communicated.

In an optional solution, to ensure a ventilation effect, vertical distances from the first gap 61 and the second gap 62 to the first sidewall 11 are less than a vertical distance between any heat generation module 70 and the first sidewall 11. Therefore, it is ensured that air can flow through an area in which the heat generation modules 70 are located when the air circulates in the first air duct 30, the second air duct a51, and the second air duct b52.

The second air duct a51 and the second air duct b52 are both surrounded by sidewalls of the body 10, the spacer board 20, the bottom board, and the cover. The second air duct a51 is used as an example. Two ends of the second air duct a51 are provided with openings, an opening at one of the ends is communicated with the opening of the U-shaped structure of the spacer board 20, and an opening at the other end is communicated with the through hole 21 of the spacer board 20.

The fan 30 is disposed in the through hole 21 of the spacer board 20. When the fan 30 works, air in the body 10 can be driven to circularly flow in the first air duct 30, the second air duct a51, and the second air duct b52, to form air circulation and reduce a temperature of air in the high-temperature area, so that the air in the body 10 is relatively balanced. For example, there is one fan 30, and the fan 30 is located at a middle position of the spacer board 20, to improve an air flow effect. It should be understood that a quantity of fans 30 provided in this embodiment of this application is not limited to one, and another quantity of fans may be used, for example, two, three, or four fans 30 or another different quantity of fans are used. However, the quantity of fans 30 provided in this embodiment of this application is less than a quantity of heat generation modules 70.

When the electronic components are disposed in the first air duct 30, both the high-temperature area (an area corresponding to the heat generation modules 70) and the low-temperature area (an area corresponding to the non-heat generation modules) in the body 10 are located in the first air duct 30. Therefore, when air flows in the first air duct 30, air in the high-temperature area and the low-temperature area may be mixed to reduce the temperature of the air in the high-temperature area. In addition, because the annular air duct is disposed in the body 10, and the heat generation modules 70 are disposed in the annular air duct, less fans 30 may be used to dissipate heat for all the heat generation modules 70.

In addition, when the fan 30 is fixed in the through hole 21, a main part of the fan 30 is located in the second air duct a51 and the second air duct b52, and only a part of the fan 30 is located in the first air duct 30, thereby reducing space occupied by the fan 30 in the first air duct 30, and reducing space that is occupied by the fan 30 and that is used to dispose the electronic components, so that components can be arranged more properly in the first air duct 30.

Refer to arrows shown in FIG. 3. The arrows show a direction of air flow in the body 10. When the air in the body 10 flows along the first air duct 30, the second air duct a51, and the second air duct b52, the fan 30 drives the air to flow in the first air duct 30, the second air duct a51, and the second air duct b52. The air in the body 10 may flow into the second air duct a51 and the second air duct b52 from the first air duct 30, and then flow into the first air duct 30 from the second air duct a51 and the second air duct b52.

When the fan 30 drives the air to flow, a rotation direction of the fan 30 is not specifically limited. The fan 30 may rotate clockwise, or may rotate counterclockwise. This is not specifically limited in this embodiment of this application.

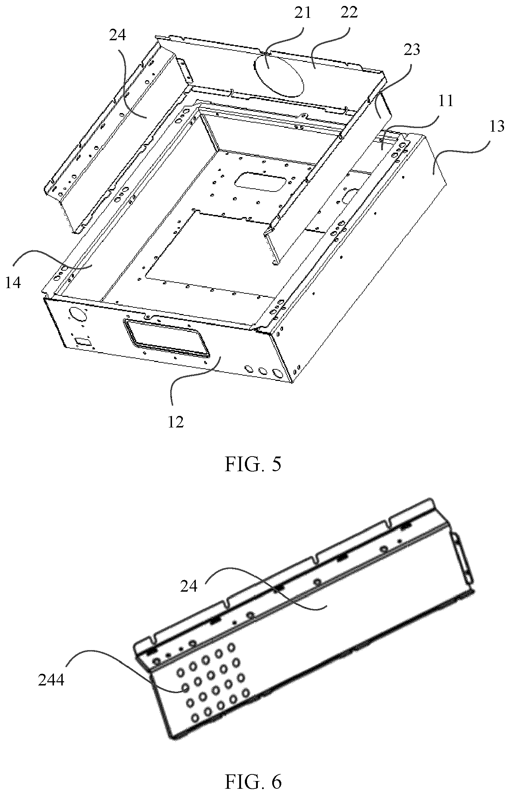

Refer to FIG. 4 and FIG. 5. FIG. 4 is a schematic diagram of a structure of the spacer board. FIG. 5 is a schematic diagram of engagement between the spacer board and the body. The spacer board 20 includes a first sub-board 22, a second sub-board 24, and a third sub-board 23. The first sub-board 22, the second sub-board 24, and the third sub-board 23 are all bar-type structures, and the first sub-board 22 is located between the second sub-board 24 and the third sub-board 23 to form the U-shaped structure. When the spacer board 20 is fixed in the body, the first sub-board 22 is parallel or approximately parallel to the first sidewall 11, the second sub-board 24 is parallel or approximately parallel to the second sidewall 14, and the third sub-board 23 is parallel or approximately parallel to the third sidewall 13. A gap between the second sub-board 24 and the second sidewall 14 and a part of a gap between the first sub-board 22 and the first sidewall 11 serve as one of the second air ducts. A gap between the third sub -board 23 and the third sidewall 13 and a part of a gap between the first sub-board 22 and the first sidewall 11 serve as the other second air duct.

When the spacer board 20 is specifically prepared, the first sub-board 22 is detachably connected to the second sub-board 24 and the third sub-board 23 by using bolted connection components. The second sub-board 24 and the third sub-board 23 are symmetrical structures. The following uses the second sub-board 24 as an example for description. A first bending structure 241 is disposed at one end of the second sub-board 24 facing the first sub-board 22. For example, the first bending structure 241 and the second sub-board 24 present a bend of approximately 90 degrees. When connected to the first sub-board 22, the first bending structure 241 may be fixedly connected to the first sub-board 22 by using a bolted connection component such as a bolt or a screw, or the first bending structure 241 may be fixedly connected to the first sub-board 22 by welding or bonding.

When the second sub-board 24 is connected to the body, a second bending structure 242 is disposed on a long sidewall of the second sub-board 24 facing the bottom board. For example, the second bending structure 242 and the second sub-board 24 present a bend of approximately 90 degrees. When connected to the bottom board, the second bending structure 242 may be fixedly connected to the bottom board by using a bolted connection component such as a bolt or a screw, or the second bending structure 242 may be fixedly connected to the bottom board by welding or bonding. A third bending structure 243 is disposed on another opposite long sidewall of the second sub-board 24. For example, the third bending structure 243 is disposed obliquely relative to the second sub-board 24, and an angle between the third bending structure 243 and the second sub-board 24 may be approximately 10 to 90 degrees. For example, the angle between the third bending structure 243 and the second sub-board 24 is 10°, 30°, 45°, 60°, 90°, or another different angle. The third bending structure 243 is fixedly connected to the second sidewall 14, to surround a part of the second air duct by using the second sidewall 14, the second sub-board 24, and the bottom board.

The third sub-board 23 is fixedly connected to the first sub-board 22, the bottom board, and the third sidewall 13 by using structures similar to those of the second sub-board 24. Therefore, details are not described herein again.

It should be understood that the spacer board 20 provided in this embodiment of this application is not limited to the form in the foregoing specific example, and the first sub-board 22, the second sub-board 24, and the third sub-board 23 may alternatively be integrated. During specific preparation, the U-shaped structure may be formed by pressing or bending.

When the spacer board 20 is engaged with the body, the second air duct is formed between the second sidewall 14 and the second sub-board 24, the first gap for communicating the first air duct and the second air duct is formed between the second sub-board 24 and the fourth sidewall 12, and the second gap for communicating the first air duct and the second air duct is formed between the third sub-board 23 and the fourth sidewall 12. Communication between the first air duct and the second air duct is implemented by designing lengths of the second sub-board 24 and the third sub-board 23.

Refer to structures shown in FIG. 2 and FIG. 4. When the first gap is formed between the spacer board and the fourth sidewall 12, the length of the second sub-board 24 is less than a length of the second sidewall 14, so that the first gap for communicating the first air duct and the second air duct is formed between the second sub-board 24 and the fourth sidewall 12. Similarly, because the length of the third sub-board 23 is less than that of the third sidewall 13, the second gap communicating the first air duct and the second air duct is formed between the third sub-board 23 and the fourth sidewall 12.

In addition, when the through hole 21 is disposed, the through hole 21 is located at a central position of the first sub-board 22, so that the fan disposed is located at the middle position of the first sub-board 22, thereby improving a ventilation effect.

FIG. 6 is another schematic diagram of a structure of the second sub-board 24. The second sub-board 24 is provided with a first air vent 244 configured to correspond to some of the plurality of heat generation modules. The first air vent 244 communicates the first air duct and the second air duct, to increase communication channels between the first air duct and the second air duct.

The first air vent 244 may have different forms. For example, the first air vent 244 includes a plurality of ventilation holes arranged in an array. A part of air can flow into the second air duct through the ventilation holes. When the first air vent 244 is disposed, a vertical distance between the first air vent 244 and the first sub-board is less than a vertical distance between a corresponding heat generation module and the first sub-board. Refer to FIG. 6. After air flows through the heat generation modules, corresponding high-temperature air may enter the second air duct through the first air vent 244, to prevent the high-temperature air from continuously circulating in the first air duct, and improve a temperature mixing effect.

Similarly, the third sub-board is provided with a second air vent configured to correspond to some of the plurality of heat generation modules. The second air vent communicates the first air duct and the other second air duct. When the second air vent is disposed, a vertical distance between the second air vent and the first sub-board is less than a vertical distance between a corresponding heat generation module and the first sub-board, to ensure that air can flow through the heat generation module.

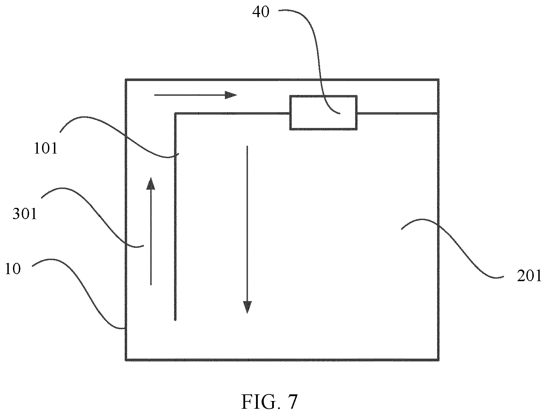

FIG. 7 shows a structure of another chassis according to an embodiment of this application. The chassis includes a body 10 and a spacer board 101. Different from the spacer board 20 shown in FIG. 2, the spacer board 101 is an inverted L-shaped structure. When the spacer board 101 is fixed in the body 10, the spacer board 101 divides space in the body 10 into a first air duct 201 and a second air duct 301. The first air duct 201 and the second air duct 301 are communicated to form an annular air duct.

There are one first air duct 201 and one second air duct 301. The first air duct 201 is a rectangular air duct, and the second air duct 301 is an inverted L-shaped air duct. Heat generation modules are disposed in the first air duct 201, and the second air duct 301 is communicated with the first air duct 201. A fan 40 is disposed on the spacer board 101. When the fan 40 works, air in the body 10 can be driven to flow in the first air duct 201 and the second air duct 301. When the foregoing solution is used, air circulation in the body can also be implemented, and less fans are used to dissipate heat for the heat generation modules.

An embodiment of this application further provides a power supply system. The power supply system may be a power supply system in data communication equipment, a server, or an energy device, and the power supply system includes the chassis and the heat sink according to any one of the implementations. The chassis and the heat sink are stacked. In the foregoing technical solution, the annular air duct is formed in the body by using the spacer board, so that air flow can be implemented with a small quantity of fans. Air in the high-temperature area (the area in which the heat generation modules are located) and air in the low-temperature area (another area other than the area in which the heat generation modules are located) in the body flow, so that temperatures of the air in the body are balanced, thereby improving a heat dissipation effect, reducing a quantity of fans, reducing space occupied by the fans, and increasing space for placing components in the body. In addition, the heat sink dissipates heat in the body to the outside through heat exchange, thereby reducing a temperature in the body and improving a working environment of the electronic components in the body.

Obviously, a person skilled in the art can make various modifications and variations to this application without departing from the scope of this application. This application is intended to cover these modifications and variations of this application provided that they fall within the scope of protection defined by the following claims and their equivalent technologies.

## Claims

1. A chassis, comprising a body and a heat dissipation component, wherein
the heat dissipation component comprises a spacer board and at least one fan disposed on the spacer board, wherein the spacer board is located in the body and disposed along sidewalls of the body, and the spacer board is a U-shaped structure;
the spacer board divides space in the body into an annular air duct, the annular air duct comprises a first air duct surrounded by the spacer board and a second air duct located between the spacer board and the sidewalls of the body, and the first air duct and the second air duct are communicated;
the first air duct has space for carrying heat generation modules; and
the at least one fan is configured to drive air in the body to circularly flow in the first air duct and the second air duct.

2. The chassis according to claim 1, wherein there are two second air ducts, and the two second air ducts are located on an outer side of the first air duct.

3. The chassis according to claim 1 or 2, wherein the two second air ducts are communicated to form a U-shaped air duct.

4. The chassis according to claim 2 or 3, wherein the spacer board comprises a first sub-board, a second sub-board, and a third sub-board;
the first sub-board is located between the second sub-board and the third sub-board to form a U-shaped structure; and
the at least one fan is disposed on the first sub-board.

5. The chassis according to claim 4, wherein the at least one fan is disposed at a central position of the first sub-board.

6. The chassis according to claim 4 or 5, wherein the body comprises a first sidewall and a fourth sidewall disposed oppositely, and an opening of the U-shaped structure of the spacer board faces the fourth sidewall;
a first gap for communicating the first air duct and the second air duct is formed between the second sub-board and the fourth sidewall; and
a second gap for communicating the first air duct and the second air duct is formed between the third sub-board and the fourth sidewall.

7. The chassis according to claim 6, further comprising the heat generation modules disposed in the body, wherein vertical distances from the first gap and the second gap to the first sidewall are less than a vertical distance between any heat generation module and the first sidewall.

8. The chassis according to claim 7, wherein the second sub-board is provided with a first air vent configured to correspond to some of a plurality of heat generation modules;
the third sub-board is provided with a second air vent configured to correspond to some of the plurality of heat generation modules;
the first air vent communicates the first air duct and the second air duct; and
the second air vent communicates the first air duct and the other second air duct.

9. The chassis according to claim 8, wherein the first air vent and the second air vent each comprise a plurality of ventilation holes arranged in an array.

10. The chassis according to claim 8 or 9, wherein a vertical distance between the first air vent and the first sub-board is less than a vertical distance between a corresponding heat generation module and the first sub-board; and
a vertical distance between the second air vent and the first sub-board is less than a vertical distance between a corresponding heat generation module and the first sub-board.

11. A power supply system, comprising the chassis and the heat sink according to any one of claims 1 to 10, wherein the chassis and the heat sink are stacked.
